# EUROPEAN PATENT APPLICATION

(11) **EP 2 423 980 A2**
(43) Date of publication of application: **29.02.2012**
(21) Application number: 11178975.6
(22) Date of filing: 26.08.2011
(51) Int. Cl.: H01L 31/05, H01L 31/042, H01L 27/142, H01L 31/18, H01L 31/068, H01L 31/0224

(54) **Integrated thin-film photovoltaic device and manufacturing method thereof**

(30) Priority: 26.08.2010 KR 20100083178
(71) Applicant: KISCO, Gyeongsangnam-do 641-370 (KR); Korea Advanced Institute of Science and Technology, Daejeon 305-701 (KR)
(72) Inventor: Lim, Koeng Su, Daejeon 305-701 (KR); Jeon, Jin-Wan, Yuseong-gu, Daejeon 305-701 (KR)
(74) Representative: Ferrari, Barbara

(57) **Abstract**

Disclosed is an integrated thin film photovoltaic device. The integrated thin film photovoltaic device includes: a substrate including trenches formed therein; a first semiconductor material layer formed on the substrate from a first basic line within each of the trenches through one side of each of the trenches to the projected surface of the substrate, which is adjacent to the one side; a second semiconductor material layer formed on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches.

## Description

### BACKGROUND

### Field

The present invention relates to an integrated thin film photovoltaic device and a manufacturing method thereof.

### Description of the Related Art

A photovoltaic device converts directly sunlight energy into electrical energy. The photovoltaic device is largely classified into a silicon based photovoltaic device, a compound based photovoltaic device and an organic photovoltaic device in accordance with a material used for the photovoltaic device.

Based on the phase of a semiconductor, the silicon based photovoltaic device is classified into a single crystalline silicon (c-Si) photovoltaic device, a polycrystalline silicon (poly-Si) photovoltaic device and an amorphous silicon (a-Si:H) photovoltaic device.

Also, based on the thickness of a semiconductor, the photovoltaic device is classified into a bulk type photovoltaic device and a thin film type photovoltaic device. The thin film type photovoltaic device includes a photovoltaic material layer having a thickness less than from several µm to several tens of µm. In the silicon based photovoltaic device, the single crystalline silicon and polycrystalline silicon photovoltaic devices belong to the bulk type photovoltaic device. The amorphous silicon photovoltaic device belongs to the thin film type photovoltaic device.

Meanwhile, the compound based photovoltaic device includes a bulk type photovoltaic device and a thin film type photovoltaic device. The bulk type photovoltaic device includes Gallium Arsenide (GaAs) and Indium Phosphide (InP) of group III-V. The thin film type photovoltaic device includes Cadmium Telluride (CdTe) of group II-VI and Copper Indium Diselenide (CulnSe2) of group I-III-VI. The organic photovoltaic device is largely classified into an organic molecule type photovoltaic device and an organic and inorganic complex type photovoltaic device. In addition, there is a dye-sensitized photovoltaic device. Here, all of the organic molecule type photovoltaic device, the organic and inorganic complex type photovoltaic device and the dye-sensitized photovoltaic device belong to a thin film type photovoltaic device.

As such, among various kinds of photovoltaic devices, the bulk type silicon photovoltaic device having high energy conversion efficiency and a relatively low manufacturing cost has been widely and generally used for a ground power. Recently, however, as a demand for the bulk type silicon photovoltaic device rapidly increases, the price thereof is now rising since a material of the bulk type silicon photovoltaic device becomes insufficient.

For this reason, it is urgently needed to develop a manufacturing method of an integrated thin film photovoltaic device which can produce in a simple manner at a low cost a photovoltaic device having high energy conversion efficiency. Particularly, in regard to a bulk type silicon solar cell, the substrate thereof occupies a large portion of the manufacturing cost of the bulk type silicon solar cell. Therefore, a research to make the substrate thinner is now actively being done.

Meanwhile, recently, active researches are now devoted to the manufacture of high efficiency integrated single crystalline or polycrystalline silicon thin film photovoltaic devices by forming a single crystalline or polycrystalline silicon thin film on an inexpensive substrate such as glass or stainless steel without use of the silicon substrate itself. Regarding the bulk type photovoltaic device of group III-V, researches are being done to the formation of a high efficiency thin film photovoltaic device on the inexpensive substrate. As regards a CIGS integrated thin film photovoltaic device, many efforts are made to manufacture the photovoltaic device by using a flexible substrate such as a polymer, stainless steel, molybdenum and the like at a low cost.

Moreover, there is also an urgent requirement for a manufacturing method of a flexible see-through type integrated thin film photovoltaic device for various applications. With regard to the see-through type integrated thin film photovoltaic device, various colors are needed for an opposite side to a light incident side, that is, a back side of the photovoltaic device. An integrated thin film photovoltaic device or a see-through type integrated thin film photovoltaic device which can generate any output voltage on the substrate having a determined area is required to meet the various applications.

### SUMMARY

One aspect of the present invention is a method for manufacturing an integrated thin film photovoltaic device. The method includes: forming trenches in a substrate; forming a first semiconductor material layer on the substrate from a first basic line within each of the trenches through one side of each of the trenches to the projected surface of the substrate, which is adjacent to the one side; forming a second semiconductor material layer on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches.

Another aspect of the present invention is an integrated thin film photovoltaic device. The integrated thin film photovoltaic device includes: a substrate including trenches formed therein; a first semiconductor material layer formed on the substrate from a first basic line within each of the trenches through one side of each of the trenches to the projected surface of the substrate, which is adjacent to the one side; a second semiconductor material layer formed on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches.

### BRIEF DESCRIPTION OF THE DRAWINGS

Fig. 1 shows a manufacturing method of an integrated thin film photovoltaic device according to embodiments of the present invention.
Figs. 2a to 2g show a manufacturing method of an integrated thin film photovoltaic device according to a first embodiment of the present invention.
Figs. 3a to 3f show a manufacturing method of an integrated thin film photovoltaic device according to a second embodiment of the present invention.
Figs. 4a to 4g show a manufacturing method of an integrated thin film photovoltaic device according to a third embodiment of the present invention.

### DETAILED DESCRIPTION OF EMBODIMENTS

A manufacturing method of an integrated thin film photovoltaic device according to an embodiment of the present invention will be described with reference to the accompanying drawings.

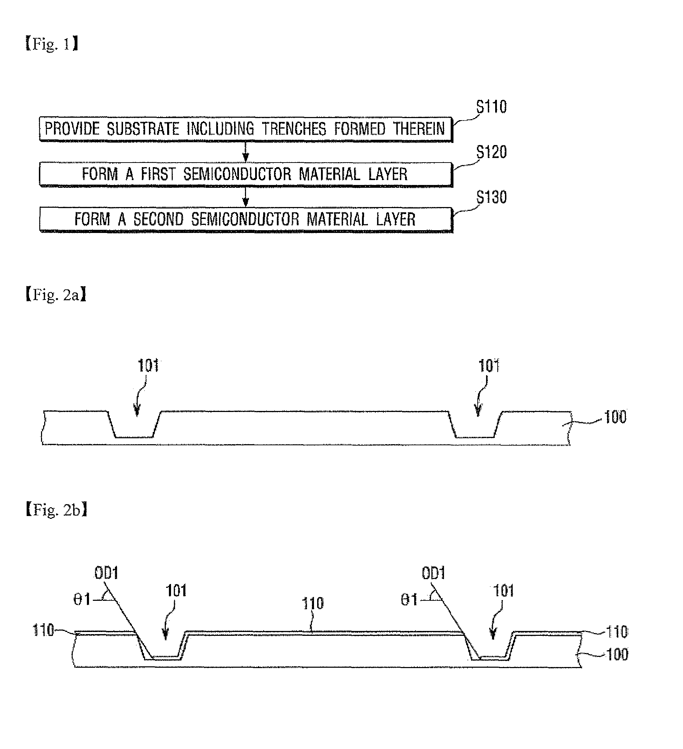

Fig. 1 shows a manufacturing method of an integrated thin film photovoltaic device according to embodiments of the present invention.

A substrate including trenches formed therein is provided (S110). A first semiconductor material layer is formed on the substrate from a first basic line within each of the trenches through one side of each of the trenches to the projected surface of the substrate, which is adjacent to the one side (S120). The first semiconductor material may be a first extrinsic semiconductor material doped with impurities.

A second semiconductor material layer is formed on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches (S130). The second semiconductor material may be a second extrinsic semiconductor material doped with impurities.

In general, the extrinsic semiconductor material doped with impurity has a resistance less than that of an intrinsic semiconductor material having no impurity. When the extrinsic semiconductor material is activated by greatly increasing the amount of the doped impurity, the resistance thereof can be sufficiently reduced. Therefore, the extrinsic semiconductor material is able to function as an electrode.

Next, regarding a case where the semiconductor material is made of silicon, the embodiments of the present invention will be described with reference to the drawings. Here, the following embodiments can be commonly applied to a case where the semiconductor material is made of semiconductor materials other than silicon.

### [First embodiment]

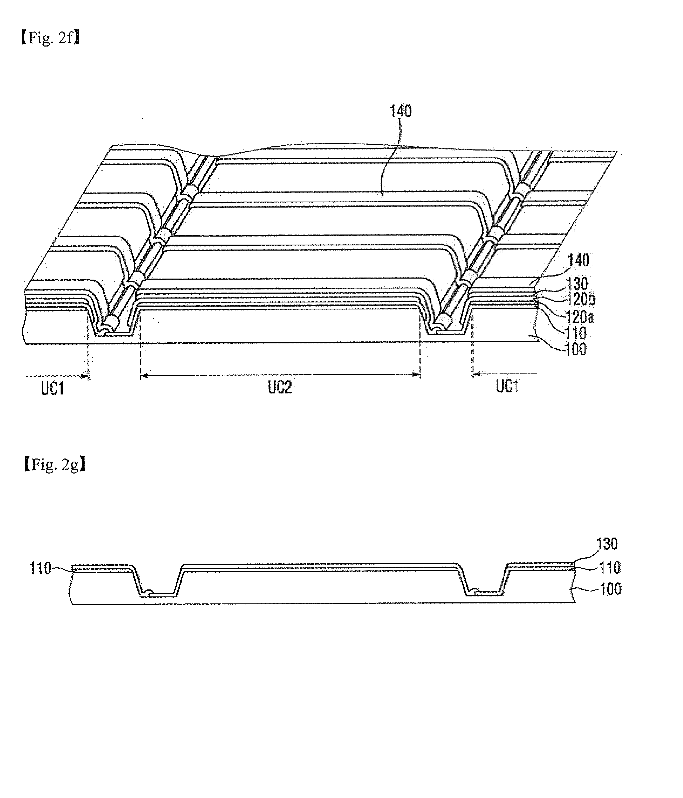

Figs. 2a to 2g show a manufacturing method of an integrated thin film photovoltaic device according to a first embodiment of the present invention.

As shown in Fig. 2a, a substrate 100 including a trench 101 formed therein is provided. It is preferred that the substrate 100 is made of one of a transparent insulating material with high optical transmittance, an opaque insulating material, a transparent conductive material and an opaque conductive material. For example, when the transparent insulating material is used, the substrate 100 may be one of a glass substrate such as soda lime glass substrate and a tempered glass substrate, a transparent plastic substrate and a transparent nano composite substrate. The nano composite is a system in which nano particles are dispersed in the form of a dispersed phase in a dispersive matrix having a continuous phase. The dispersive matrix may be formed of one of an organic solvent, a plastic material, a metallic material and a ceramic material. The nano particle may be formed of one of a plastic material, a metallic material and a ceramic material. When the dispersive matrix is the organic solvent, the organic solvent is removed by heat treatment, and then the nano particles only may remain. When the opaque insulating material is used, the substrate 100 is one of a ceramic substrate, an opaque plastic substrate and an opaque nano composite substrate.

When the transparent conductive material is used, the substrate 100 is a transparent conductive polymer substrate. When the opaque conductive material is used, the substrate 100 is one of a stainless steel substrate, an aluminum substrate, a copper substrate, a tungsten substrate, a molybdenum substrate, a nickel substrate and a chrome substrate. When the substrate 100 is made of the transparent or opaque conductive material, an insulating layer should be coated on the entire surface of the substrate 100. When a through-hole is formed in the substrate for the purpose of manufacturing a see-through type integrated thin film photovoltaic device, the entire surface including the wall surface of the through-hole should be coated with the insulating layer. In this case, the back side of the see-through type integrated thin film photovoltaic device may be coated with a desired color by using a spray method, printing method and a painting method and the like.

When at least one of the transparent conductive material, the opaque conductive material, the glass material, the plastic material, the nano composite material, and the ceramic material and the like are molten and used for manufacturing the substrate, the trenches 101 are formed in the form of stripes by using a press method or an embossing process before the molten substrate is hardened. Moreover, the trenches 101 Can be formed in the substrates that have been formed of the aforementioned materials by applying a hot-press method or a hot-embossing method.

The substrate 100 may include a thin film that is made of one of the ceramic material, the plastic material and the nano composite material and is coated on one of the transparent insulating material, the opaque insulating material, the transparent conductive material and opaque conductive material. In this case, the trenches may be formed by using the hot-press method or the hot-embossing method in the thin film made of one of the ceramic material, the plastic material and the nano composite material.

Also, during the process in which the thin film made of one of the ceramic material, the plastic material and the nano composite material is coated on one of the transparent insulating material, the opaque insulating material, the transparent conductive material and opaque conductive material, the trenches may be formed in the thin film made of one of the ceramic material, the plastic material and the nano composite material by using the press method or the embossing method. Here, the plastic material and the nano composite material may include a thermosetting material or a UV curable material. Since the trenches are formed in the thin film made of the plastic material or the nano composite material and coated on the glass, it is easier to form the trenches than to directly form the trenches in the glass.

The trenches 101 can be also formed not only by the press method, the embossing method, the hot-press method and the hot-embossing method but by any one of a mechanical process such as a wet etching method, a dry etching method, a grinding method and a cutting method, and an optical processing such as a laser scribing method.

Both the aforementioned material of the substrate and the aforementioned method for forming the trench can be commonly applied to the following embodiments.

As shown in Fig. 2b, a first extrinsic silicon material layer 110 is formed on a portion of the bottom surface of and one side of the trench 101 and on the area between the adjacent trenches 101. A first intrinsic silicon material is obliquely discharged (OD1) in the environment of a first impurity or with the first impurity at an angle of θ1 1 with respect to the substrate 100 from one side, or similarly a first extrinsic semiconductor material is obliquely discharged (OD1) at an angle of θ1 with respect to the substrate 100 from one side. Subsequently, during the process in which the first extrinsic semiconductor material is deposited on the substrate 100 or after deposited on the substrate 100, the first extrinsic semiconductor material is crystallized by means of solid phase crystallization (SPC), metal induced crystallization (MIC), joule induced crystallization (JIC), an electron beam and ion cluster beam (ICB), a laser beam and a rapid thermal annealing (RTA) and the like. As a result, the first extrinsic polycrystalline silicon layer 110 is formed on the substrate 100. Here, based on a substrate temperature or a growth condition, the first extrinsic single crystalline silicon layer 110 may be epitaxially grown on the substrate 100. Hereafter, the polycrystalline silicon includes the epitaxially grown single crystalline silicon. The first extrinsic silicon is not hereby deposited on a portion of the bottom surface of and the other side of the trench 101 formed on the substrate 100.

The first extrinsic silicon layer 110 may be formed by using a deposition method having straightness such as e-beam evaporation, a thermal evaporation, a spray evaporation and a sputtering and the like, all of which use the silicon material as a source or a target. However, the method for forming the first extrinsic silicon layer 110 is not limited to this. Such a deposition method can be also applied to not only a first intermediate intrinsic silicon layer, a second intermediate intrinsic silicon layer and a second extrinsic silicon layer, but also applied to the following embodiments.

The first extrinsic silicon layer 110 is doped with the first impurity and has a first polarity. For example, when the first impurity is a group III element, the first extrinsic silicon layer 110 is a p-type polycrystalline silicon layer. When the first impurity is a group V element, the first extrinsic silicon layer 110 is an n-type polycrystalline silicon layer.

After the first extrinsic polycrystalline silicon layer 110 is formed, defect annealing by a heat treatment process and hydrogen passivation can be carried out.

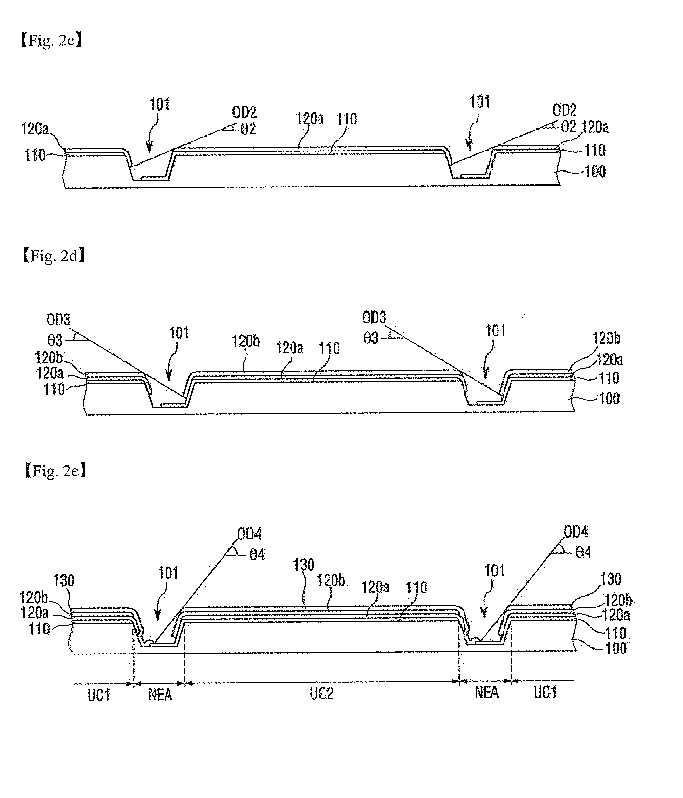

As shown in Fig. 2c, a first intermediate intrinsic silicon material is obliquely discharged (OD2) at an angle of θ2 with respect to the substrate from one side or the opposite side to the one side, and then is crystallized during or after being deposited on the first extrinsic polycrystalline silicon layer 110. Accordingly, a first intermediate intrinsic polycrystalline silicon layer 120a is formed on the first extrinsic polycrystalline silicon layer 110. Here, the first intermediate intrinsic polycrystalline silicon layer 120a is formed by the intrinsic silicon material. In this case, the impurity of the first extrinsic polycrystalline silicon layer 110 may be diffused into the first intermediate intrinsic polycrystalline silicon layer 120a.

As a result, a first impurity concentration of the first intermediate intrinsic polycrystalline silicon layer 120a is less than that of the first extrinsic polycrystalline silicon layer 110. When the first impurity is a group III element, the first extrinsic polycrystalline silicon layer 110 is a p+ type polycrystalline silicon layer, and the first intermediate intrinsic polycrystalline silicon layer 120a may include the p-type polycrystalline silicon layer. When the first impurity is a group V element, the first extrinsic polycrystalline silicon layer 110 is an n+ type polycrystalline silicon layer, and the first intermediate intrinsic polycrystalline silicon layer 120a may include the n-type polycrystalline silicon layer.

As shown in Fig. 2d, a second intermediate intrinsic silicon material is obliquely discharged (OD3) at an angle of θ3 with respect to the substrate from the opposite side to the side from which the first intermediate intrinsic silicon material has been discharged, and then is crystallized during or after being deposited on the first intermediate intrinsic polycrystalline silicon layer 120a. As a result, a second intermediate intrinsic polycrystalline silicon layer 120b is formed on the first intermediate intrinsic polycrystalline silicon layer 120a. Here, second intermediate intrinsic polycrystalline silicon layer 120b is formed by the intrinsic silicon material. The second intermediate intrinsic polycrystalline silicon layer 120b will be described in detail later.

As shown in Fig. 2e, a second intrinsic silicon material is obliquely discharged (OD4) in the environment of a second impurity or with the second impurity at an angle of θ4 with respect to the substrate 100 from the opposite side to the one side, or similarly a second extrinsic silicon material is obliquely discharged at an angle of θ4 with respect to the substrate 100 from the opposite side to the one side, and then is crystallized during or after being deposited on the second intermediate intrinsic polycrystalline silicon layer 120b. As a result, a second extrinsic polycrystalline silicon layer 130 is formed on the second intermediate intrinsic polycrystalline silicon layer 120b. Here, the second extrinsic polycrystalline silicon layer 130 located in a unit cell 1 (UC1), that is, in one area that generates electromotive force by light among the areas between the trenches 101, is connected within the trench to the first extrinsic polycrystalline silicon layer 110 located in a second unit cell 2 (UC2), that is, in another adjacent area that generates electromotive force by light. As a result, the adjacent unit cells (UCs) are electrically connected in series to each other. Here, the areas that generate the light correspond to the unit cells UC1 and UC2.

In general, since the extrinsic polycrystalline silicon has an electrical resistance less than that of the intrinsic polycrystalline silicon, in the first embodiment of the present invention, the first extrinsic polycrystalline silicon layer 110 and the second extrinsic polycrystalline silicon layer 130 function as electrodes. Therefore, the first extrinsic polycrystalline silicon layer 110 and the second extrinsic polycrystalline silicon layer 130 which are located in the adjacent areas, respectively, are connected to each other within the trench 101, so that the adjacent unit cells UC1 and UC2 are electrically connected in series to each other. In some cases, TCO, a thin-film metal, a metal grid or TCO/metal grid may be inserted beneath the first extrinsic polycrystalline silicon layer 110 and/or on the second extrinsic polycrystalline silicon layer 130.

When the first impurity is a group III element, the second impurity is a group V element. When the first impurity is a group V element, the second impurity is a group III element. Accordingly, the second impurity of the second extrinsic polycrystalline silicon layer 130 may be diffused into the second intermediate intrinsic polycrystalline silicon layer 120b. Therefore, when the second impurity is a group V element, the second extrinsic polycrystalline silicon layer 130 is the n+ type polycrystalline silicon layer, and the second intermediate intrinsic polycrystalline silicon layer 120b includes the n-type polycrystalline silicon layer. When the second impurity is a group III element, the second extrinsic polycrystalline silicon layer 130 is the p+ type polycrystalline silicon layer, and the second intermediate intrinsic polycrystalline silicon layer 120b includes the p-type polycrystalline silicon layer. Therefore, a second impurity concentration of the second intermediate intrinsic polycrystalline silicon layer 120b is less than that of the second extrinsic polycrystalline silicon layer 130.

The first embodiment of the present invention shows the processes of forming the first intermediate intrinsic polycrystalline silicon layer 120a and the second intermediate intrinsic polycrystalline silicon layer 120b. Further, Fig, 2g shows that the first extrinsic polycrystalline silicon layer 110 and the second extrinsic polycrystalline silicon layer 130 may contact with each other without forming the first intermediate intrinsic polycrystalline silicon layer 120a and the second intermediate intrinsic polycrystalline silicon layer 120b. That is, though the first extrinsic polycrystalline silicon layer 110 and the second extrinsic polycrystalline silicon layer 130 contact with each other in one same unit cell, a p-n junction can be formed.

Here, the first intrinsic silicon material is obliquely discharged in the environment of the first impurity or with the first impurity with respect to the substrate 100 from one side, or similarly a first extrinsic silicon material is obliquely discharged with respect to the substrate 100 from one side, and then is crystallized during or after being deposited on the substrate 100. As a result, the first extrinsic polycrystalline silicon layer 110 is formed on the substrate 100. Subsequently, the second intrinsic silicon material is obliquely discharged in the environment of the second impurity or with the second impurity with respect to the substrate 100 from the opposite side to the one side, or similarly a second extrinsic silicon material is obliquely discharged with respect to the substrate 100 from the opposite side, and then is crystallized during or after being deposited on the first extrinsic polycrystalline silicon layer 110. As a result, the second extrinsic polycrystalline silicon layer 130 is formed on the first extrinsic polycrystalline silicon layer 110.

In the following second and third embodiments, a first extrinsic polycrystalline silicon layer 210 and 310 can contact with a second extrinsic polycrystalline silicon layer 230 and 330 without forming first and second intermediate intrinsic polycrystalline silicon layers 220a, 220b, 320a, and 320b.

When the first intermediate intrinsic polycrystalline silicon layer 120a is located between the first extrinsic polycrystalline silicon layer 110 and the second extrinsic polycrystalline silicon layer 130, the first intermediate intrinsic polycrystalline silicon layer 120a prevents the end of the first extrinsic polycrystalline silicon layer 110 from contacting with and being short-circuited with the second extrinsic polycrystalline silicon layer 130. Also, the first intermediate intrinsic polycrystalline silicon layer 120a prevents the first extrinsic silicon and the second extrinsic silicon from being mixed with each other during the process in which the first intermediate intrinsic polycrystalline silicon layer 120a is crystallized. The first intermediate intrinsic polycrystalline silicon layer 120a also contributes to the formation of a wider depletion region. The second intermediate intrinsic polycrystalline silicon layer 120b prevents the end of the second extrinsic polycrystalline silicon layer 130 from contacting with and being short-circuited with the first extrinsic polycrystalline silicon layer 110. Also, the second intermediate intrinsic polycrystalline silicon layer 120b prevents the first extrinsic silicon and the second extrinsic silicon from being mixed with each other during the process in which the second intermediate intrinsic polycrystalline silicon layer 120b is crystallized. The second intermediate intrinsic polycrystalline silicon layer 120b also contributes to the formation of a wider depletion region.

Since a method of crystallizing the first intermediate intrinsic silicon and the second intermediate intrinsic silicon into the first and the second intermediate intrinsic polycrystalline silicon layers 120a and 120b, and a method of crystallizing the second extrinsic silicon into the second extrinsic polycrystalline silicon layer 130 have been described through the first extrinsic polycrystalline silicon layer 110, the repetitive description thereof will be omitted.

The first embodiment shows that the first extrinsic polycrystalline silicon layer 110, the first and the second intermediate intrinsic polycrystalline silicon layers 120a and 120b, and the second extrinsic polycrystalline silicon layer 130 are sequentially formed. However, after the first extrinsic silicon, the first intermediate intrinsic silicon and the second intermediate intrinsic silicon, and the second extrinsic silicon are deposited and then simultaneously crystallized, the first extrinsic polycrystalline silicon layer 110, the first and the second intermediate intrinsic polycrystalline silicon layers 120a and 120b, and the second extrinsic polycrystalline silicon layer 130 may be formed at the same time.

The defect annealing and hydrogen passivation may be also carried out whenever the first extrinsic polycrystalline silicon layer 110, the first and the second intermediate intrinsic polycrystalline silicon layers 120a and 120b, and the second extrinsic polycrystalline silicon layer 130 are formed. Otherwise, after the first extrinsic polycrystalline silicon layer 110, the first and the second intermediate intrinsic polycrystalline silicon layers 120a and 120b, and the second extrinsic polycrystalline silicon layer 130 are formed, the defect annealing and hydrogen passivation may be carried out at once. Such features can be applied not only to the first embodiment but also to the following second and third embodiments.

As described above, the first and the second extrinsic polycrystalline silicon layers 110 and 130, and the first and the second intermediate intrinsic polycrystalline silicon layers 120a and 120b can be formed by the oblique deposition. In other words, in the integrated thin film photovoltaic device according to the embodiment of the present invention, the unit cells UC1 and UC2 can be electrically connected in series to each other without a scribing process or an etching process. Since the unit cells UC1 and UC2 are formed by the oblique deposition, the first and the second extrinsic polycrystalline silicon layers 110 and 130, and the first and the second intermediate intrinsic polycrystalline silicon layers 120a and 120b can be self-aligned. Therefore, there is no requirement for an extra mask process.

As such, since the unit cells can be formed and be electrically connected in series by the oblique deposition process without using the mask process, the scribing process or the etching process, the integrated thin film photovoltaic device can be simply manufactured at a low cost.

Further, since the adjacent unit cells UC1 and UC2 can be electrically connected in series to each other within the one narrow trench 101 of several µm to several tens of µm, a non effective area (NEA) unable to convert light into a photo electromotive force is reduced and the energy conversion efficiency of the integrated thin film photovoltaic device is increased. Moreover, since the first extrinsic polycrystalline silicon layer 110 and the second extrinsic polycrystalline silicon layer 130 are able to function as an electrode, an extra electrode layer may not be required, so that it is possible to simplify the manufacturing process thereof and to reduce the manufacturing cost thereof.

Meanwhile, as shown in Fig. 2f, an auxiliary electrode layer 140 having an electrical resistance less than that of the second extrinsic polycrystalline silicon layer 130 may be formed on the second extrinsic polycrystalline silicon layer 130. The second extrinsic polycrystalline silicon layer 130 may have an electrical resistance relatively greater than that of a metal electrode. Therefore, the more the width of each of the unit cells UC 1 and UC2 increases, the more the width of the second extrinsic polycrystalline silicon layer 130 increases, so that the electrical resistance of the second extrinsic polycrystalline silicon layer 130 increases as well. As such, when the electrical resistance of the second extrinsic polycrystalline silicon layer 130 is increased, the photoelectric conversion efficiency of the photovoltaic device is reduced. Here, the areas of the unit cells UC1 and UC2 are independent areas that generate electromotive force by light.

Particularly, the substrate 100 of the photovoltaic device has a certain area. Therefore, for the purpose of increasing the efficiency, it is required to reduce a ratio of the non effective area incapable of generating the photo electromotive force to the entire area of the substrate 100, and is required to increase a ratio of an effective area generating electric current to the entire area of the substrate 100. For the sake of increasing the ratio of the effective area to the entire area of the substrate 100, the widths of the unit cell areas UC1 and UC2 should be increased.

When the auxiliary electrode layer 140 having an electrical resistance less than that of the second extrinsic polycrystalline silicon layer 130 is formed, it is possible to compensate the efficiency degradation of the photovoltaic device caused by the electrical resistance of the second extrinsic polycrystalline silicon layer 130. Besides, since the widths of the unit cell areas UC 1 and UC2 can be increased without efficiency degradation of the unit cells, the generating power of the integrated photovoltaic device, i.e. module can be increased according to the increase of the effective areas of the module.

As such, the efficiency of the photovoltaic device is guaranteed irrespective of the increase of the effective area. Therefore, it is easy to change the number of the unit cells UC 1 and UC2 formed on the substrate 100. For example, when the width of the substrate 100 is 80 cm and the maximum widths of the unit cells UC1 and UC2 and the like are 2 mm with consideration of the electrical resistance of the second extrinsic polycrystalline silicon layer 130, at least 400 unit cells UC1 and UC2 can be formed on the substrate 100. The 400 unit cells UC1 and UC2 are electrically connected in series. Therefore, when one unit cell UC1 and UC2 or the like generates a voltage of 0.6V, the integrated photovoltaic device formed on the substrate 100 having its width of 80 cm is able to supply minimally a voltage of 240V.

When the auxiliary electrode layer 140 is formed to contact with the second extrinsic polycrystalline silicon layer 130, the efficiency of the photovoltaic device is guaranteed irrespective of the widths of the unit cell UC1 and UC2. Therefore, it is easy to change the number of the unit cells that can be formed on the substrate 100. That is, the auxiliary electrode layer 140 is able to allow the photovoltaic device to flexibly supply the power.

The function of such an auxiliary electrode layer 140 is applied not only to the first embodiment but also to the embodiments to be described later.

The auxiliary electrode layer 140 of the first embodiment of the present invention includes at least one of Al, Cu, Au, Ag, Zn, W, Ni and Cr. The auxiliary electrode layer 140 can be formed by means of any one of a thermal evaporation method and an ink jet method, which use a metal mask, a jet spray method, a screen printing method, a nano imprint method and a stamping method.

Each impurity concentration of the first and the second extrinsic semiconductor materials should be very high in order that the adjacent unit cells are electrically connected in series to each other within the trench. Here, electrical current may flow by tunnel effect through the p-n junction of the first and the second extrinsic semiconductor materials which are overlapped with each other within the trench. However, even when the impurity concentrations of the first and the second extrinsic semiconductor materials are not very high, the first extrinsic semiconductor material is overlapped within the trench with the auxiliary electrode layer formed on the second extrinsic semiconductor material, or the second extrinsic semiconductor material is overlapped within the trench with the auxiliary electrode layer formed beneath the first extrinsic semiconductor material, or the auxiliary electrode layers formed beneath the first extrinsic semiconductor material and on the second extrinsic semiconductor material are overlapped with each other within the trench. Therefore, the electrical series connection can be obtained by causing electrical current to flow through the auxiliary electrode layer having a low electrical resistance.

The material and the formation method of the auxiliary electrode layer 140 can be applied not only to the first embodiment but also to the embodiments to be described later.

### [Second embodiment]

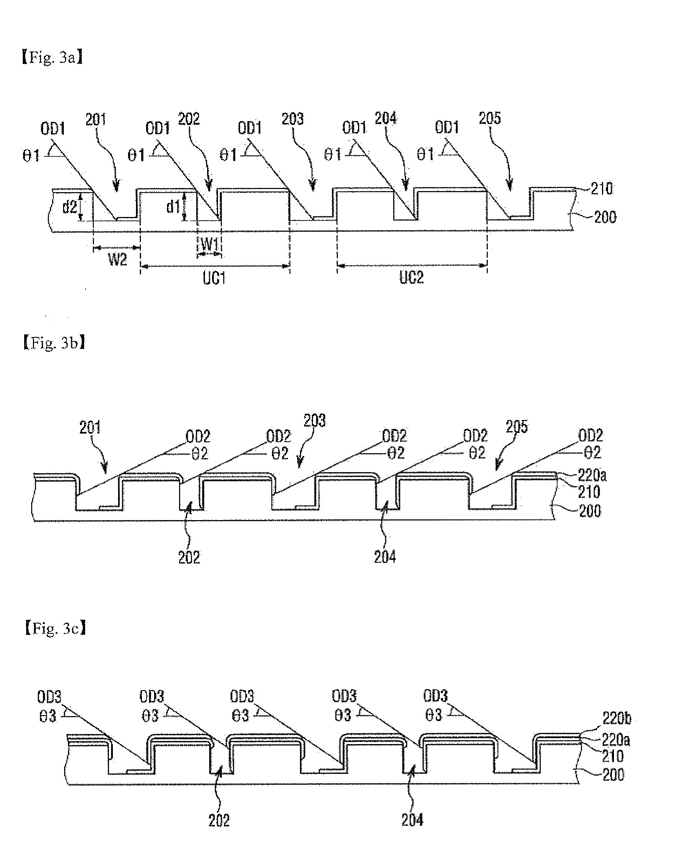

Figs. 3a to 3f show a manufacturing method of a see-through type integrated thin film photovoltaic device according to a second embodiment of the present invention.

As shown in Fig. 3a, provided is a substrate 200 in which trenches 201, 203 and 205 and holes 202 and 204 have been formed.

The holes 202 and 204 are located between the trenches 201, 203 and 205. Adjacent unit cells are electrically connected in series to each other within the trenches 201, 203 and 205. The holes 202 and 204 allow light to transmit therethrough. The trenches 201, 203 and 205 and the holes 202 and 204 may be formed in the same manner. Since the methods for forming the trenches 201, 203 and 205 and the holes 202 and 204 have been described in the first embodiment, descriptions thereof will be omitted. Here, the trenches 201, 203 and 205 and the holes 202 and 204 can be formed at the same time.

A ratio of the depths d1 of the holes 202 and 204 to the widths w1 or the diameters w1 of the holes 202 and 204 may be greater than a ratio of the depths d2 of the trenches 201, 203 and 205 to the widths w2 of the trenches 201, 203 and 205. For example, as shown in Fig. 3a, the holes 202 and 204 are formed to have the widths w1 less than those of the trenches 201, 203 and 205 and to have the same depths as those of the trenches 201, 203 and 205. Otherwise, though not shown, the holes 202 and 204 may be formed to have the depths d1 greater than those of the trenches 201, 203 and 205 and to have the same widths as those of the trenches 201, 203 and 205. Otherwise, though not shown, the holes 202 and 204 may penetrate the substrate 200.

The aforementioned forming methods intend that the first extrinsic silicon, the first intermediate intrinsic silicon, the second intermediate intrinsic silicon and the second extrinsic silicon are not deposited on the bottom surface of the holes 202 and 204 during the process in which the not only the first extrinsic silicon but also the first intermediate intrinsic silicon, the second intermediate intrinsic silicon and the second extrinsic silicon are obliquely deposited.

Through this, light transmits through the holes 202 and 204, and then a see-through type integrated thin film photovoltaic device is formed. Such holes 202 and 204 have a cross section of a circular shape, a polygonal shape and an elliptical shape, and are uniformly or ununiformly distributed on the area of each unit cell UC. However, it is recommended that the sum of the cross section of the holes formed in the area of each unit cell be the same as that of others.

Meanwhile, as shown in Fig. 3a, the first intrinsic silicon material is obliquely discharged (OD1) in the environment of the first impurity or with the first impurity at an angle of θ1 with respect to the substrate from one side, or similarly the first extrinsic silicon material is obliquely discharged (OD1) at an angle of θ1 with respect to the substrate from one side, and then is crystallized during or after being deposited. As a result, the first extrinsic polycrystalline silicon layer 210 is formed on the portions of the bottom surface of and one side of each of the trenches 201, 203 and 205, on one side of each of the holes 202 and 204 and on the areas between the adjacent trenches 201, 203 and 205.

Since the first impurity and the first extrinsic polycrystalline silicon layer 210 have been described in the first embodiment, descriptions thereof will be omitted.

As shown in Fig. 3b, the first intermediate intrinsic silicon is obliquely discharged (OD2) at an angle of θ2 with respect to the substrate from one side or the opposite side to the one side, and then is crystallized during or after being deposited on the first extrinsic polycrystalline silicon layer 210. Accordingly, a first intermediate intrinsic polycrystalline silicon layer 220a is formed on the first extrinsic polycrystalline silicon layer 210. Since the first intermediate intrinsic polycrystalline silicon layer 220a has been described in the first embodiment, the description thereof will be omitted.

As shown in Fig. 3c, the second intermediate intrinsic silicon is obliquely discharged (OD3) at an angle of θ3 with respect to the substrate from the opposite side to the side from which the first intermediate intrinsic silicon has been discharged, and then is crystallized during or after being deposited on the first intermediate intrinsic polycrystalline silicon layer 220a. As a result, a second intermediate intrinsic polycrystalline silicon layer 220b is formed on the first intermediate polycrystalline silicon layer 220a. Since the second intermediate intrinsic polycrystalline silicon layer 220b has been described in the first embodiment, the description thereof will be omitted.

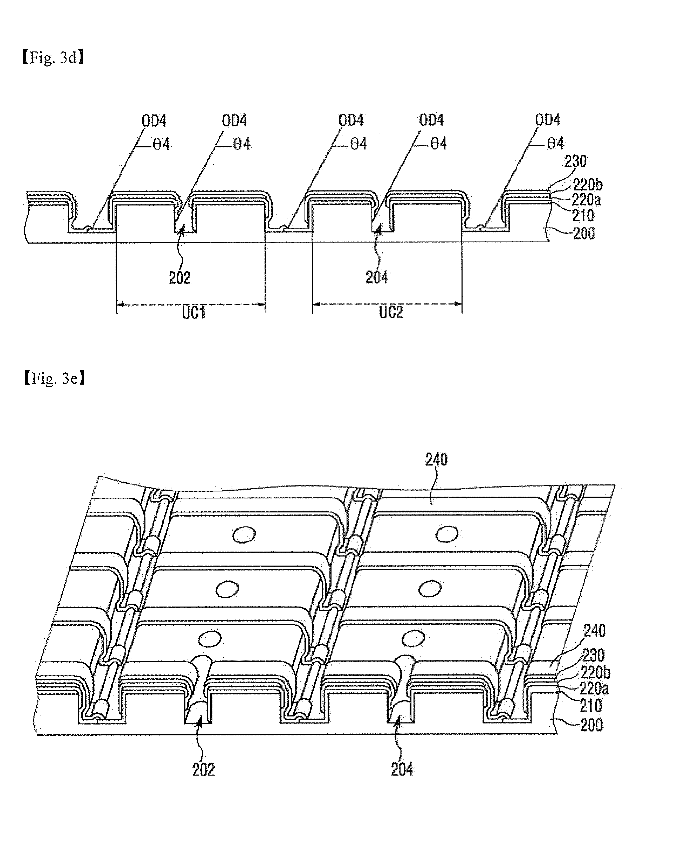

As shown in Fig. 3d, the second intrinsic silicon is obliquely discharged (OD3) in the environment of the second impurity or with the second impurity at an angle of θ4 with respect to the substrate 200 from the opposite side to the one side, or similarly the second extrinsic silicon material is obliquely discharged (OD3) at an angle of θ4 with respect to the substrate 200 from the opposite side to the one side, and then is crystallized during or after being deposited on the second intermediate intrinsic polycrystalline silicon layer 220b. As a result, a second extrinsic polycrystalline silicon layer 230 is formed on the second intermediate intrinsic polycrystalline silicon layer 220b. Since the second extrinsic polycrystalline silicon layer 230 has been described in the first embodiment, the description thereof will be omitted. Therefore, the adjacent unit cells UC1 and UC2 are electrically connected in series to each other.

As shown in Fig. 3e, an auxiliary electrode layer 240 having an electrical resistance less than that of the second extrinsic polycrystalline silicon layer 230 is formed on the second extrinsic polycrystalline silicon layer 230. Since the auxiliary electrode layer 240 has been described above, the description thereof will be omitted.

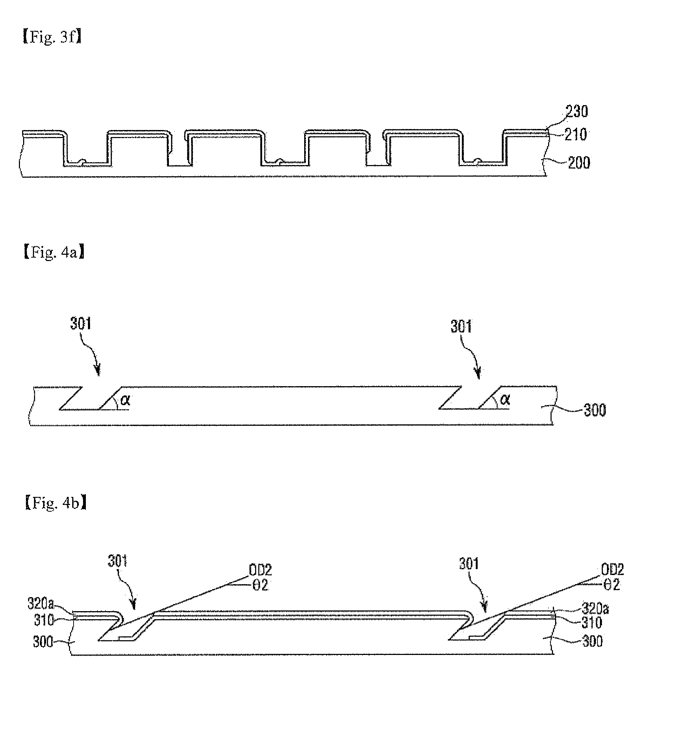

Meanwhile, as shown in Fig. 3f, the first extrinsic polycrystalline silicon layer 210 and the second extrinsic polycrystalline silicon layer 230 may contact with each other without forming the first intermediate intrinsic polycrystalline silicon layer 220a and the second intermediate intrinsic polycrystalline silicon layer 220b. Here, the first intrinsic silicon material is obliquely discharged in the environment of the first impurity or with the first impurity with respect to the substrate 200 from one side, or similarly the first extrinsic silicon material is obliquely discharged with respect to the substrate 200 from one side, and then is crystallized during or after being deposited on the substrate 200. As a result, the first extrinsic polycrystalline silicon layer 210 is formed on the substrate 200. Subsequently, the second intrinsic silicon material is obliquely discharged in the environment of the second impurity or with the second impurity with respect to the substrate 200 from the opposite side to the one side, or similarly the second extrinsic silicon material is obliquely discharged with respect to the substrate 200 from the opposite side, and then is crystallized during or after being deposited on the first extrinsic polycrystalline silicon layer 210. As a result, the second extrinsic polycrystalline silicon layer 230 is formed on the first extrinsic polycrystalline silicon layer 210.

### [Third embodiment]

Figs. 4a to 4g show a manufacturing method of an integrated thin film photovoltaic device according to a third embodiment of the present invention.

As shown in Fig. 4a, provided is a substrate 300 including trenches 301 which are separated from each other at a predetermined interval and have both sides inclined at an angle of α in the same direction with respect to the surface of the substrate.

As shown in Fig. 4b, the first intrinsic silicon material is vertically discharged in the environment of the first impurity or with the first impurity with respect to the substrate, or the first extrinsic silicon material is vertically discharged with respect to the substrate, and then is crystallized during or after being deposited on a portion of the bottom surface of and one side of the trench 301 and on the area between the adjacent trenches 301.

Accordingly, a first extrinsic polycrystalline silicon layer 310 is formed. In the third embodiment, since the trench is inclined, the first extrinsic polycrystalline silicon layer 310 can be formed without an oblique deposition process or a mask process. The method for forming the first extrinsic polycrystalline silicon layer 310 has been described in the first embodiment, the description thereof will be omitted.

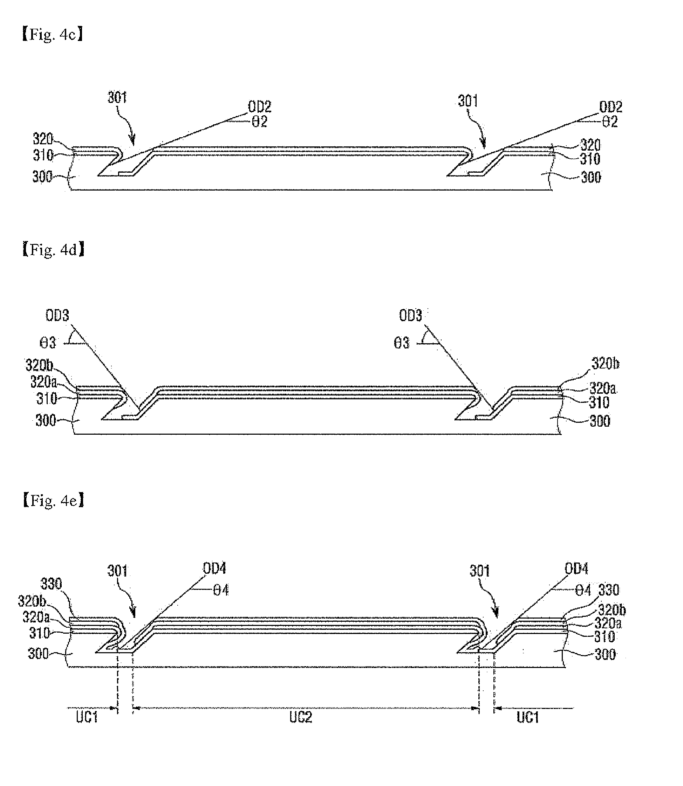

As shown in Fig. 4c, the first intermediate intrinsic silicon is obliquely discharged (OD2) at an angle of θ2 with respect to the substrate from one side or the opposite side to the one side, and then is crystallized during or after being deposited on the first extrinsic polycrystalline silicon layer 310. Accordingly, a first intermediate intrinsic polycrystalline silicon layer 320a is formed on the first extrinsic polycrystalline silicon layer 310. Since the first intermediate intrinsic polycrystalline silicon layer 320a has been described in the first embodiment, the description thereof will be omitted.

As shown in Fig. 4d, the second intermediate intrinsic silicon is obliquely discharged (OD3) at an angle of θ3 with respect to the substrate from the opposite side to the side to which the first intermediate intrinsic silicon has been discharged, and then is crystallized during or after being deposited on the first intermediate polycrystalline silicon layer 320a. As a result, a second intermediate intrinsic polycrystalline silicon layer 320b is formed on the first intermediate intrinsic polycrystalline silicon layer 320a. Since the second intermediate intrinsic polycrystalline silicon layer 320b has been described in the first embodiment, the description thereof will be omitted.

As shown in Fig. 4e, the second intrinsic silicon is obliquely discharged (OD4) in the environment of the second impurity or with the second impurity at an angle of θ4 with respect to the substrate from the opposite side to the one side, or similarly the second extrinsic semiconductor material is obliquely discharged (OD4) at an angle of θ4 with respect to the substrate from the opposite side to the one side, and then is crystallized during or after being deposited on the second intermediate intrinsic polycrystalline silicon layer 320b. As a result, a second extrinsic polycrystalline silicon layer 330 is formed on the second intermediate intrinsic polycrystalline silicon layer 320b. Since the second extrinsic polycrystalline silicon layer 330 has been described in the first embodiment, the description thereof will be omitted. Therefore, the adjacent unit cells UC1 and UC2 are electrically connected in series to each other.

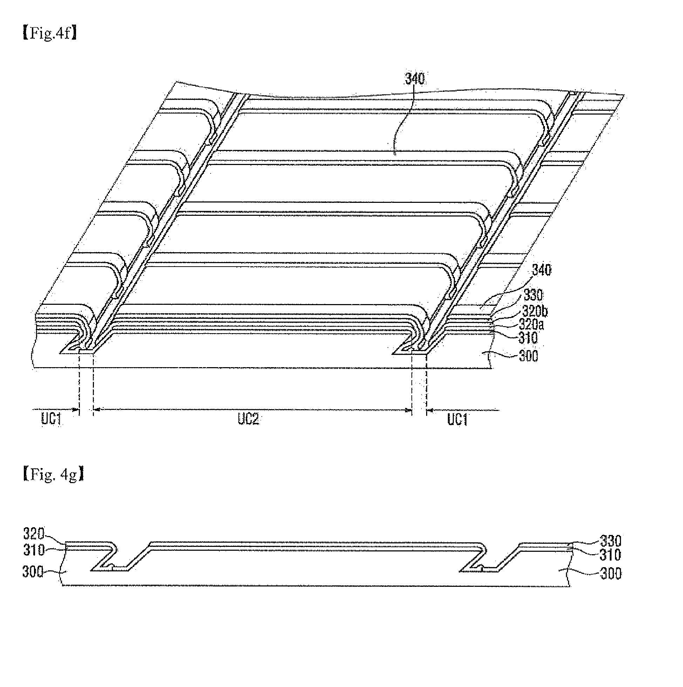

As shown in Fig. 4f, an auxiliary electrode layer 340 having an electrical resistance less than that of the second extrinsic polycrystalline silicon layer 330 is formed on the second extrinsic polycrystalline silicon layer 330. Since the auxiliary electrode layer 340 has been described above, the description thereof will be omitted.

Meanwhile, as shown in Fig. 4g, the first extrinsic polycrystalline silicon layer 310 and the second extrinsic polycrystalline silicon layer 330 may contact with each other without forming the first intermediate intrinsic polycrystalline silicon layer 320a and the second intermediate intrinsic polycrystalline silicon layer 320b. Here, the first intrinsic silicon material in the environment of the first impurity or with the first impurity, or the first extrinsic silicon material is deposited, and then is crystallized during or after being deposited on the substrate 300. As a result, the first extrinsic polycrystalline silicon layer 310 is formed on the substrate 300. As described above, in the third embodiment, the trench 301 is inclined, the oblique deposition does not needed. Subsequently, the second intrinsic silicon material in the environment of the second impurity or with the second impurity, or the second extrinsic silicon material is obliquely discharged with respect to the substrate 300, and then is crystallized during or after being deposited on the first extrinsic polycrystalline silicon layer 310. As a result, the second extrinsic polycrystalline silicon layer 330 is formed on the first extrinsic polycrystalline silicon layer 310.

The silicon material from the first to the third embodiments of the present invention can be replaced with any material capable of generating carriers when sunlight is incident For example, a semiconductor material includes at least one of a silicon based material, a compound based material, an organic material and a dry dye-sensitized based material. Therefore, the present invention can be applied to the thin film solar cell made of various materials.

Regarding a multi-junction cell, in order to improve the energy conversion efficiency of the thin film solar cell, an intermediate layer may be formed at the interfaces of cells constituting the multi-junction cell. In this case, the intermediate layer is made of an insulating material or a conductive material. A transparent material can be also used as the material of the intermediate layer. For example, the intermediate layer includes at least one of silicon nitride, silicon oxide, silicon carbide and metal oxide. Also, the intermediate layer includes at least one of metal oxide based materials, that is, ZnO, SnO₂ and ITO.

While the embodiment of the present invention has been described with reference to the accompanying drawings, it can be understood by those skilled in the art that the present invention can be embodied in other specific forms without departing from its spirit or essential characteristics. Therefore, the foregoing embodiments and advantages are merely exemplary and are not to be construed as limiting the present invention. The present teaching can be readily applied to other types of apparatuses. The description of the foregoing embodiments is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

## Claims

1. A method for manufacturing an integrated thin film photovoltaic device, the method comprising:
forming trenches in a substrate;
forming a first semiconductor material layer on the substrate from a first basic line within each of the trenches through one side of each of the trenches to the projected surface of the substrate, which is adjacent to the one side;
forming a second semiconductor material layer on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches.

2. The method of claim 1, further comprising forming a first intermediate intrinsic semiconductor layer and a second intermediate intrinsic semiconductor layer on the resultant substrate between the forming the first semiconductor material layer and the forming the second semiconductor material layer.

3. The method of claim 1 or 2, further comprising forming a hole allowing light to transmit therethrough in the projected area of the substrate between the trenches.

4. The method of claim 2,
wherein the forming the first semiconductor material layer comprises depositing obliquely from one side a first intrinsic semiconductor material in the environment of a first impurity, a first impurity and a first intrinsic semiconductor material or a first semiconductor material on the resultant substrate;
wherein the forming the first intermediate intrinsic semiconductor layer comprises depositing obliquely from the one side or from the opposite side to the one side a first intermediate intrinsic semiconductor material on the resultant substrate;
wherein the forming the second intermediate intrinsic semiconductor layer comprises depositing obliquely a second intermediate intrinsic semiconductor material on the resultant substrate from the opposite side to the side from which the first intermediate intrinsic semiconductor material is deposited; and
wherein the forming the second semiconductor material layer comprises depositing obliquely a second intrinsic semiconductor material in the environment of a second impurity, a second impurity and a second intrinsic semiconductor material or a second semiconductor material on the resultant substrate from the opposite side to the side from which the first semiconductor material is deposited.

5. The method of claim 4, wherein the first semiconductor material, the first intermediate intrinsic semiconductor material, the second intermediate intrinsic semiconductor material and the second semiconductor material are crystallized during each deposition or at least one of the depositions, or are crystallized after each deposition or at least one of the depositions.

6. The method of any one of claims 1 to 5, further comprising forming, at least one of beneath the first semiconductor material layer and on the second semiconductor material layer, an auxiliary electrode layer having an electrical resistance less than those of the first and the second semiconductor material layers.

7. The method of claim 4, wherein the deposition of each of the first semiconductor material, the first intermediate intrinsic semiconductor material, the second intermediate intrinsic semiconductor material and the second semiconductor material is performed by at least one method of an e-beam evaporation, a thermal evaporation, a spray evaporation and a sputtering, each of which has straightness.

8. An integrated thin film photovoltaic device comprises:
a substrate including trenches formed therein;
a first semiconductor material layer formed on the substrate from a first basic line within each of the trenches through one side of each of the trenches to the projected surface of the substrate, which is adjacent to the one side;
a second semiconductor material layer formed on a resultant substrate from a second basic line on the first semiconductor material layer within each of the trenches through the other side of each of the trenches to the projected surface of the resultant substrate, which is adjacent to the other side, so that a portion of the first semiconductor material layer and a portion of the second semiconductor material layer are overlapped with each other within each of the trenches.

9. The integrated thin film photovoltaic device of claim 8, further comprising a first intermediate intrinsic semiconductor layer and a second intermediate intrinsic semiconductor layer, all of which are located between the first semiconductor material layer and the second semiconductor material layer on the projected surface of the substrate and such that the first semiconductor material layer is overlapped with the second semiconductor material layer in at least a part of an area between the first basic line and the second basic line within each of the trenches.

10. The integrated thin film photovoltaic device of claim 9, wherein at least one of the first semiconductor material layer, the second semiconductor material layer, the first intermediate intrinsic semiconductor layer and the second intermediate intrinsic semiconductor layer is crystallized.

11. The integrated thin film photovoltaic device of any one of claims 8 to 10, wherein a hole allowing light to transmit therethrough is located in the projected area of the substrate between the trenches.

12. The integrated thin film photovoltaic device of any one of claims 8 to 11, wherein the first semiconductor material layer comprises a first impurity and the second semiconductor material layer comprises a second impurity different from the first impurity, so that the first and the second semiconductor material layers form a p-n junction.

13. The integrated thin film photovoltaic device of any one of claims 8 to 12, further comprising an auxiliary electrode layer being located at least one of beneath the first semiconductor material layer and on the second semiconductor material layer and having an electrical resistance less than those of the first and the second semiconductor material layers.

14. The integrated thin film photovoltaic device of claim 8, further comprising a first auxiliary electrode layer and a second auxiliary electrode layer being located beneath the first semiconductor material layer and on the second semiconductor material layer, respectively, and having electrical resistances less than those of the first and the second semiconductor material layers, wherein at least one of the first auxiliary electrode layer and the second auxiliary electrode layer is a transparent conductive oxide (TCO).

15. The integrated thin film photovoltaic device of claim 14, wherein the first semiconductor material layer is overlapped within the trench with the second auxiliary electrode layer formed on the second semiconductor material layer, wherein the second semiconductor material layer is overlapped within the trench with the first auxiliary electrode layer formed beneath the first semiconductor material layer, or wherein the first and the second auxiliary electrode layers are overlapped with each other within the trench.
